# EUROPÄISCHE PATENTSCHRIFT

(11) **EP 1 277 246 B1**
(45) Veröffentlichungstag und Bekanntmachung des Hinweises auf die Patenterteilung: **21.04.2010**
(21) Anmeldenummer: 01925189.1
(22) Anmeldetag: 27.04.2001
(51) Int. Cl.: H01L 51/42

(54) **PHOTOVOLTAISCHE ZELLE**
PHOTOVOLTAIC CELL
CELLULE PHOTOVOLTAIQUE

(30) Priorität: 27.04.2000 AT 7332000
(43) Veröffentlichungstag der Anmeldung: 22.01.2003
(73) Patentinhaber: Konarka Austria Forschungs-und Entwicklungs GMBH, 4010 Linz (AT)
(72) Erfinder: SHAHEEN, Sean, Arizona, AZ 85331 (US); BRABEC, Christoph, A-4040 Linz (AT); FROMHERZ, Thomas, A-4112 Rottenegg (AT); PADINGER, Franz, A-4490 St. Florian (AT); SARICIFTCI, Sedar, A-4040 Linz (AT); GLOETZL, Erhard, A-4020 Linz (AT)
(74) Vertreter: Peterreins, Frank
(86) Internationale Anmeldenummer: PCT/AT2001/000130
(87) Internationale Veröffentlichungsnummer: WO 2001/086734

(56) Entgegenhaltungen:
- OUALI L ET AL: "OLIGO(PHENYLENEVINYLENE)/FULLERENE PHOTOVOLTAIC CELLS: INFLUENCE OFMORPHOLOGY" ADVANCED MATERIALS, VCH VERLAGSGESELLSCHAFT, WEINHEIM, DE, Bd. 11, Nr. 18, 17. Dezember 1999 (1999-12-17), Seiten 1515-1518, XP000902384 ISSN: 0935-9648
- ROMAN L S ET AL: "PHOTODIODE PERFORMANCE AND NANOSTRUCTURE OF POLYTHIOPHENE/C60 BLENDS" ADVANCED MATERIALS, VCH VERLAGSGESELLSCHAFT, WEINHEIM, DE, Bd. 9, Nr. 15, 1. Dezember 1997 (1997-12-01), Seiten 1164-1168, XP000725204 ISSN: 0935-9648
- GAO J ET AL: "Efficient photodetectors and photovoltaic cells from composites of fullerenes and conjugated polymers: photoinduced electron transfer" INTERNATIONAL CONFERENCE ON SCIENCE AND TECHNOLOGY OF SYNTHETIC METALS (ICSM '96), SNOWBIRD, UT, USA, 28 JULY-2 AUG. 1996, Bd. 84, Nr. 1-3, Seiten 979-980, XP001020875 Synthetic Metals, 1 Jan. 1997, Elsevier, Switzerland ISSN: 0379-6779
- CONBOY J C ET AL: "IMPACT OF SOLVENT VAPOR ANNEALING ON THE MORPHOLOGY AND PHOTOPHYSICS OF MOLECULAR SEMICONDUCTOR THIN FILMS" JOURNAL OF PHYSICAL CHEMISTRY. B, MATERIALS, SURFACES, INTERFACES AND BIOPHYSICAL, WASHINGTON, DC, US, Bd. 102, Nr. 23, 4. Juni 1998 (1998-06-04), Seiten 4516-4525, XP000964644 ISSN: 1089-5647
- SHAHEEN S E ET AL: "2.5% efficient organic plastic solar cells" APPLIED PHYSICS LETTERS, 5 FEB. 2001, AIP, USA, Bd. 78, Nr. 6, Seiten 841-843, XP001020433 ISSN: 0003-6951

## Beschreibung

Die Erfindung bezieht sich auf eine photovoltaische Zelle mit einer photoaktiven Schicht aus zwei Komponenten, nämlich einer konjugierten Polymerkomponente als Elektronendonator und einer Fullerenkomponente als Elektronenakzeptor.

Kunststoffe mit ausgedehnten π-Elektronensystemen, bei denen abwechselnd Einfach- und Doppelbindungen aufeinanderfolgen, werden als konjugierte Kunststoffe bezeichnet. Diese konjugierten Kunststoffe weisen hinsichtlich der Elektronenenergie mit Halbleitern vergleichbare Energiebänder auf, so daß sie auch durch ein Dotieren vom nichtleitenden, in den metallisch leitenden Zustand überführt werden können. Beispiele für solche konjugierten Kunststoffe sind Polyphenylene, Polyvinylphenylene (PPV), Polythiophene oder Polyaniline. Der Wirkungsgrad der Energieumwandlung von photovoltaischen Polymerzellen aus einem konjugierten Polymer liegt allerdings typischerweise zwischen 10⁻³ und 10⁻² %. Zur Verbesserung dieses Wirkungsgrades wurden zwar bereits heterogene Schichten aus zwei konjugierten Polymerkomponenten vorgeschlagen (US 5 670 791 A), von denen eine Polymerkomponente als Elektronendonator und die andere Polymerkomponente als Elektronenakzeptor dienen. Durch den Einsatz von Fullerenen, insbesondere Buckminsterfullerenen C₆₀, als Elektronenakzeptoren (US 5 454 880 A) konnte die sonst übliche Ladungsträgerrekombination in der photoaktiven Schicht weitgehend vermieden werden, was zu einer Wirkungsgradsteigerung auf 0,6 % bis 1 % unter AM (Air Mass) 1,5 Bedingungen führte. Trotzdem bleibt der erreichbare Wirkungsgrad für einen wirtschaftlichen, technischen Einsatz von solchen photoaktiven Schichten zum Aufbau von photovoltaischen Zellen im allgemeinen zu gering.

Roman, L. et al. beschreibt die Verwendung von konjugierten halbleitenden Polymeren in photovoltaischen Bauelementen in "Photodiode Performance and Nanostructure of Polythiophene/C60 Blends", Advanced Materials, vol. 9, no. 15, 1. Dezember 1997, Seiten 1164 to 1168.

Gao, J. et al. beschreibt polymer-basierte Photodetektoren und photovoltaische Zellen, die hergestellt wurden unter Verwendung des konjugierten Polymers (MEH-PPV) als Donator und von C60 als Akzeptor, in "Efficient photodetectors and photovoltaic cells from composites of fullerenes and conjugated polymers: photoinduced electron transfer", International conference on science and technology of synthetic metals (ICSM '96), Snowbird, UT, USA, 28. Juli - 2. August 1996, vol. 84, no. 1-3, Seiten 979-989.

Die Veröffentlichung von Ouali, L. et al. "Oligo (phenylenevinylene)/Fullerene Photovoltaic Cells: Influence of Morphology", Advanced Materials, vol. 11, no. 18, 17. Dezember 1999, Seiten 1515 bis 1518, liegt ebenfalls auf diesem technischen Gebiet.

Der Erfindung liegt somit die Aufgabe zugrunde, eine photovoltaische Zelle der eingangs geschilderten Art so auszugestalten, daß eine weitere Steigerung des Wirkungsgrades der Energieumwandlung möglich wird.

Die Erfindung löst die gestellte Aufgabe durch die photovoltaische Zelle gemäß Anspruch 1 bzw. das Verfahren gemäß Anspruch 2. Anspruch 3 gibt eine bevorzugte Ausführungsform an.

Der Erfindung liegt die Erkenntnis zugrunde, daß eine wirksame Ladungstrennung nur im Berührungsbereich zwischen dem Elektronendonator und dem Elektronenakzeptor sichergestellt werden kann, so daß nach einer Photoanregung der konjugierten Polymerkomponente die Anregungsenergie nur in den Berührungsbereichen mit der Fullerenkomponente an diese in Form von Elektronen weitergegeben wird. Wird die durchschnittliche größte Korngröße der Komponenten und Mischphasen der photoaktiven Schicht kleiner als 500 nm gehalten, so kann aufgrund der damit verbundenen Oberflächenvergrößerung der Berührungsanteil zwischen den beiden Komponenten entsprechend gesteigert werden, was zu einer deutlichen Verbesserung der Ladungstrennung führt. Der von dieser Ladungstrennung abhängige Wirkungsgrad stieg auf kennzeichnende 2,5 % unter simulierten AM 1,5 Bedingungen.

Zur Herstellung photovoltaischer Zellen mit einer photoaktiven Schicht, deren durchschnittliche Korngröße kleiner als 500 nm ist, kann in üblicher Weise eine Mischung aus den beiden Komponenten und einem Lösungsmittel als Film auf eine mit einer Elektrodenschicht versehene Trägerschicht aufgebracht werden, bevor dieser die photoaktive Schicht bildende Film mit einer Gegenelektrode abgedeckt wird. Es muß jedoch dafür gesorgt werden, daß als Lösungsmittel ein entsprechendes Feinungsmittel für die beiden Komponenten eingesetzt wird, um die angestrebte Feinkörnigkeit der photoaktiven Schicht sicherzustellen. Mit besonderem Vorteil kann dabei Chlorbenzol als Feinungsmittel eingesetzt werden.

Anhand der Zeichnung wird die Wirkung der feinkörnigen Strukturierung der photoaktiven Schicht einer erfindungsgemäßen photovoltaischen Zelle näher erläutert. Es zeigen
- Fig. 1: den grundsätzlichen Aufbau einer erfindungsgemäßen photovoltaischen Zelle in einem Schnitt,
- Fig. 2: die Oberflächenstruktur einer herkömmlichen photoaktiven Schicht,
- Fig. 3: die Oberflächenstruktur einer erfindungsgemäßen photoaktiven Schicht,
- Fig. 4: die Strom-Spannungskennlinie einer herkömmlichen und einer erfindungsgemäßen photovoltaischen Zelle und
- Fig. 5: die auf die Wellenlänge der Photoanregung bezogene Ladungsausbeute je einfallender Lichtleistung einerseits für eine herkömmliche und anderseits für eine erfindungsgemäße photovoltaische Zelle.

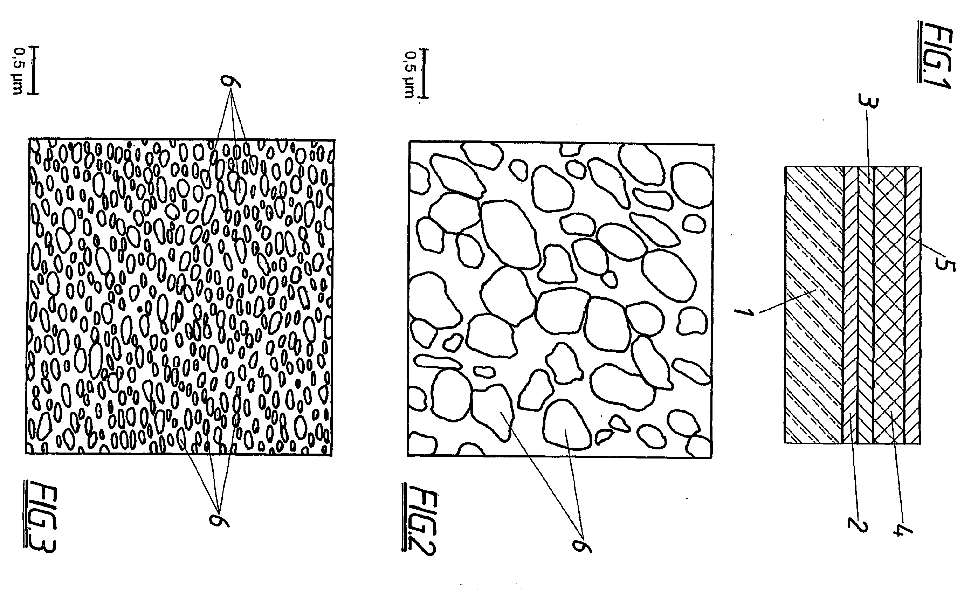

Gemäß der Fig. 1 besteht die photovoltaische Zelle aus einem lichtdurchlässigen Glasträger 1, auf dem eine Elektrodenschicht 2 aus einem Iridium/Zinn-Oxid (ITO) aufgebracht ist. Diese Elektrodenschicht 2 weist im allgemeinen eine vergleichsweise rauhe Oberflächenstruktur auf, so daß sie mit einer Glättungsschicht 3 aus einem durch eine Dotierung elektrisch leitfähig gemachten Polymer, üblicherweise PEDOT, abgedeckt wird. Auf diese Glättungsschicht 3 wird die photoaktive Schicht 4 aus zwei Komponenten mit einer Schichtdicke je nach Auftragungsverfahren von beispielsweise 100 nm bis einige µm aufgetragen, bevor die Gegenelektrode 5 aufgebracht wird. Bei der Verwendung von ITO als Iochsammelnde Elektrode wird als elektronensammelnde Elektrode Aluminium eingesetzt, das auf die photoaktive Schicht 4 aufgedampft wird.

Die photoaktive Schicht besteht aus einem konjugierten Polymer, vorzugsweise einem PPV-Derivat, als Elektronendonator und funktionalisiertes Fulleren PCBM als Elektronenakzeptor. Unter dem Begriff Polymer sind dabei sowohl Hochpolymere als auch Oligomere zu verstehen. Diese beiden Komponenten werden mit einem Lösungsmittel vermischt und als Lösung auf die Glättungsschicht 3 z. B. durch Aufschleudern oder Auftropfen aufgetragen. Als übliches Lösungsmittel wird Toluol eingesetzt, das jedoch nicht die gewünschte Feinstruktur der photoaktiven Schicht 4 sicherstellen kann, wie dies die Fig. 2 zeigt, in der die typische Oberflächenstruktur einer solchen photoaktiven Schicht mit Toluol als Lösungsmittel dargestellt ist. Es läßt sich in einer Atomkraftaufnahme (Tapping-mode AFM images), wie sie in den Fig. 2 und 3 schematisch wiedergegeben ist, insbesondere die Kornstruktur der Fullerenkomponente 6 bzw. einer Mischphase entnehmen, während die Polymerkomponente bzw. eine weitere Mischphase im wesentlichen die Zwischenräume zwischen den ausgeprägten Körnern ausfüllt. Anhand der eingezeichneten Längeneinheit ergibt sich eine maximale Korngröße erheblich größer als 500 nm.

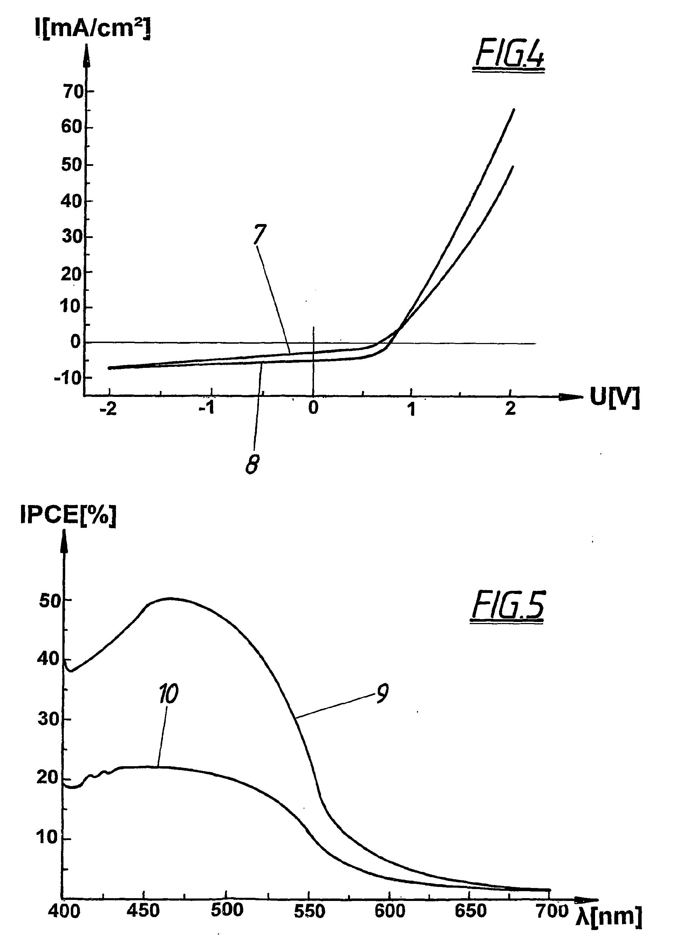

Wird jedoch erfindungsgemäß als Lösungsmittel ein Feinungsmittel, vorzugsweise Chlorbenzol, eingesetzt, so erhält man bei sonst übereinstimmender Zusammensetzung der aktiven Schicht 4 eine erheblich feinere Struktur, die sich gemäß der Fig. 3 in einer entsprechend glatteren Oberflächenstruktur auswirkt. Die mit Hilfe des Feinungsmittels erzielbare durchschnittliche Korngröße kleiner als 500 nm der photoaktiven Schicht 4 bringt eine deutliche Vergrößerung der Anzahl der Berührungsstellen zwischen dem Elektronendonator und dem Elektronenakzeptor und damit eine erheblich verbesserte Ladungstrennung und verringerte Ladungsrekombination mit sich, was aus den Spannungs-Stromkennlinien unmittelbar abgelesen werden kann. In der Fig. 4 ist die Stromdichte I der zu vergleichenden photovoltaischen Zellen über der Spannung U aufgetragen, und zwar bei einer Anregungsenergie von 80 mW/cm² unter simulierten AM 1,5 Bedingungen. Vergleicht man die Kennlinie 7 der photovoltaischen Zelle mit der grobkörnigeren Struktur der photoaktiven Schicht 4 mit der Kennlinie 8, die für eine photovoltaische Zelle mit einer feinkörnigen Struktur der photoaktiven Schicht 4 aufgenommen wurde, so erkennt man unmittelbar die verbesserten Verhältnisse bei einer erfindungsgemäßen photovoltaischen Zelle gemäß der Kennlinie 8. Der bei der Spannung 0 V gemessene Kurzschlußstrom betrug bei der bekannten Zelle 2,79 mA/cm², bei der erfindunggemäßen Zelle 5,24 mA/cm². Da sich auch die Leerlaufspannung von 710 mV auf 770 mV vergrößerte, konnte eine Wirkungsgradsteigerung von ca. 1 % auf 2,6 % erzielt werden, wobei zu berücksichtigen ist, daß sich der Füllfaktor aufgrund der feineren Struktur der erfindungsgemäßen photoaktiven Schicht von 0,40 auf 0,52 vergrößerte.

Besonders deutlich sind die erfindungsgemäßen Wirkungen anhand der Fig. 5 abzulesen, in der die Ladungsausbeute je einfallender Lichtleistung IPCE[%] = 1240.Iₖ[µA/cm²] / λ[nm].Iₗ[W/m²] über der Wellenlänge A für die zu vergleichenden photovoltaischen Zellen aufgetragen ist. Mit Iₖ ist der Kurzschlußstrom und mit Iₗ die Lichtleistung in die obige Formel einzutragen. Es zeigt sich, daß gemäß der Kennlinie 9 für eine erfindungsgemäße Zelle im Vergleich zur Kennlinie 10 der herkömmlichen Zelle ca. die doppelte Ladungsausbeute je einfallender Lichtleistung anfällt, wenn die Feinstruktur der heterogenen photoaktiven Schicht 4 eine durchschnittliche Körnung kleiner als 500 nm aufweist.

## Patentansprüche

1. Photovoltaische Zelle mit einer photoaktiven Schicht (4) aus zwei Komponenten, nämlich einer konjugierten Polymerkomponente als Elektronendonator und einer Fullerenkomponente als Elektronenakzeptor, wobei die beiden Komponenten und deren Mischphasen zumindest in Abschnitten der photoaktiven Schicht (4) eine durchschnittliche größte Korngröße kleiner als 500 nm aufweisen,
**dadurch gekennzeichnet, dass**
die Fullerenkomponente aus dem funktionalisierten Fulleren PCBM besteht.

2. Verfahren zum Herstellen einer photovoltaischen Zelle nach Anspruch 1, wobei eine Mischung aus den beiden Komponenten und einem Lösungsmittel auf einer mit einer Elektrodenschicht versehenen Trägerschicht als Film aufgebracht und dann dieser Film mit einer Gegenelektrode abgedeckt wird, wobei der Mischung aus den beiden Komponenten ein Feinungsmittel als Lösungsmittel beigefügt wird.

3. Verfahren nach Anspruch 2, wobei Chlorbenzol als Feinungsmittel verwendet wird.

## Claims

1. A photovoltaic cell with a photoactive layer (4) of two components, namely a conjugated polymer component as electron donator and a fullerene component as electron acceptor, wherein both components and their blended phases have at least in portions of the photoactive layer (4) an average maximum grain size lower than 500 nm,
**characterized in that**
the fullerene component consists of the functionalized fullerene PCBM.

2. A method for manufacturing a photovoltaic cell according to claim 1, wherein the blend from both components and a solvent is disposed as a film on a carrier layer having an electrode layer and then this film is covered by a counter-electrode, wherein a refining agent is added as solvent to the blend from both components.

3. The method according to claim 2, wherein chlorobenzene is used as refining agent.

## Revendications

1. Cellule photovoltaïque comprenant une couche photo-active (4) à deux composants, à savoir un composant polymère conjugué à titre de donneur d'électrons et un composant fullerène à titre d'accepteur d'électrons, les deux composants et leurs phases mixtes présentant au moins dans des portions de la couche photo-active (4) une taille de particules maximum moyenne inférieure à 500 nm,
**caractérisée en ce que** le composant fullerène est un fullerène fonctionnalisé PCBM.

2. Procédé pour réaliser une cellule photovoltaïque selon la revendication 1, dans lequel un mélange des deux composants et d'un solvant est déposé sous forme de film sur une couche porteuse pourvue d'une couche formant électrode, et ce film est ensuite recouvert d'une électrode antagoniste, dans lequel on ajoute au mélange des deux composants un agent d'affinage à titre de solvant.

3. Procédé selon la revendication 2, dans lequel on utilise à titre d'agent d'affinage du chlorobenzol.
